## Europäisches Patentamt

## European Patent Office

## Office européen des brevets

(11) Veröffentlichungsnummer: **0 006 443**
**A1**

(12) # EUROPÄISCHE PATENTANMELDUNG

(21) Anmeldenummer: 79101563.9

(51) Int. Cl.³: **G 11 C 19/08**, G 05 F 7/00

(22) Anmeldetag: 22.05.79

(30) Priorität: 16.06.78 US 916188

(43) Veröffentlichungstag der Anmeldung: 09.01.80
Patentblatt 80/1

(84) Benannte Vertragsstaaten: **DE FR GB**

(71) Anmelder: **International Business Machines
Corporation, Armonk, N.Y. 10504 (US)**

(72) Erfinder: **Braun, Roland Joseph, 500 Jones Road,
Vestal, NY 13850 (US)**
Erfinder: **Carden, Gary Richard, R.D. 6, Box 25
Loughlin, Rd., Binghamton, NY 13904 (US)**

(74) Vertreter: **Busch, Robert, Dipl.-Ing., Schönaicher
Strasse 220, D-7030 Böblingen (DE)**

(54) **Magnetblasenbaueinheit.**

(57) Eine Magnetblasen-Baueinheit (1), die für ein Feldzugriffsverfahren ausgelegt ist, enthält ein flaches inneres Solenoid (14) und in hierzu senkrechter Richtung ein dieses umgebendes, flaches, äußeres Solenoid (13), so daß bei entsprechender Stromflußsteuerung durch die beiden Solenoide (13, 14) ein in Ebene dieser flachen Solenoide (13, 14) gerichtetes Drehmagnetfeld bereitgestellt werden kann, das auf innerhalb des inneren Solenoids (13) angebrachte Magnetblasenchips (2) zur Weiterleitung hierin auftretender Magnetblasen einzuwirken vermag. Zwischen dem inneren Solenoid (14) und den Magnetchipoberflächen sind Magnetfeldausgleichs-Leitungsfolien (9, 10) angebracht. Diese Magnetfeldausgleichs-Leitungsfolien (9, 10) tragen Sorge für eine im wesentlichen gleichförmige Magnetflußverteilung innerhalb des inneren Solenoids (14) und für einen Schutz gegen schädliche Einwirkungen des magnetischen Streufeldes zwischen den Solenoidswicklungen, die aus konstruktiven Gründen nicht gleichförmig angebracht sein können. Infolgedessen ergibt sich eine im wesentlichen gleichförmige Drehmagnetfeldverteilung an den Magnetblasenchipoberflächen, wie es zur Magnetblasenweiterleitung vorteilhaft ist.

Magnetblasenbaueinheit

Die Erfindung betrifft eine Anordnung, wie sie dem Oberbegriff des Patentanspruchs 1 zu entnehmen ist.

Es ist eine altbekannte Tatsache, daß bei Fehlen jeglicher Ausgleichsvorkehrungen die in Magnetschichtebene gerichtete, durch zwei orthogonal zueinander ausgerichtete Drehfeldspulen bereitgestellte Drehmagnetfeldverteilung über einer Magnetblaseneinrichtung einer Glockenkurve entspricht, deren Maximum in der Spulenmitte und deren Minima im Bereich der Seitenkanten liegen.

Eine bekannt gewordene Lösung zur Herbeiführung einer gleichförmigen Drehmagnetfeldverteilung besteht darin, unterschiedliche Abstände zwischen benachbarten Windungen des jeweiligen Solenoids vorzusehen, anstatt diese Abstände gleichzuhalten. So wird z. B. gemäß der US-Patentschrift 4 045 786 der jeweilige Abstand zwischen benachbarten Windungen des umgebenden, in gedruckter Schalttechnik ausgeführten, orthogonalen Solenoidsystems, ausgehend vom Spulenmittelpunkt des jeweiligen Solenoids, allmählich bis zu seinen Kanten verringert. Es ist ganz offensichtlich, daß ein derartiges System äußerste Sorgfalt bei Herstellung bedingt, um die erforderlichen unterschiedlichen, jedoch gleichzeitig symmetrischen Abstandsbedingungen zwischen den Windungen zu erfüllen. Darüberhinaus dürfte ein entsprechendes Herstellungsverfahren zur Bereitstellung diskreter Solenoide unter Einhaltung derartiger Bedingungen noch komplizierter sein. Schließlich könnte noch die variable Abstandsbedingung selbst zu einer gewissen Welligkeit in der Gleichförmigkeit des hierdurch bereitgestellten Drehmagnetfeldes führen.

In der Veröffentlichung "Double Stacked Bubble Memory Module", von D. G. McBride, im "IBM Technical Disclosure Bulletin",

EN 977 019

0006443

Bd. 20, Nr. 8, Januar 1978, Seiten 3054 bis 3055 wird auf eine derartige Welligkeit eines Drehmagnetfeldes Bezug genommen, die sich durch die Abstände zwischen den Solenoidwicklungen eines die Magnetblasenchips einschließenden orthogonalen Solenoidsystems ergibt. Die Magnetblasenchips sind dabei auf einer Seite eines Substrats angeordnet, auf dessen anderer Seite sich eine Anzahl von Eingangs- und Ausgangsanschlußstiften befindet. Im einzelnen sind diese Anschlußstifte zu Doppelreihen geordnet, die sich längs der Substratkanten erstrecken. Bei einer derartigen Struktur liegen die Windungen des inneren Solenoids um dem die Magnetblasenchips enthaltenden Substrat, und zwar zwischen den an zwei gegenüber liegenden Substratkanten angeordneten Anschlußstiften. Dieses Substrat ist auf ein Zwischensubstrat gesteckt, bei dem die Anschlußstifte auf dem gegenüber zuvor senkrecht gerichteten Reihen an den Außenkanten liegen. Das äußere Solenoid liegt dann auch hier wiederum zwischen den Anschlußstiftreihen an den Außenkanten. Mit einer derartigen Konstruktion wird zwar erreicht, daß die Solenoidbindungen unbeeinflußt von Anschlußstiften jeweils gleichen Abstand zueinander aufweisen, jedoch wird hierbei aber die Herstellung insofern verkompliziert als bei Erfordernis eines Zwischensubstrats zusätzliche Arbeitgänge zum Aufbringen gedruckter Schaltungsleitungszüge sowie für den Zusammenbau erforderlich sind. Hinzu kommt dann noch, daß der eingangs erwähnte Glockenverlauf der Magnetfeldverteilung in nachteiliger Weise beibehalten bleibt.

Es ist weiterhin vorgeschlagen worden eine Hilfswicklung zur Bereitstellung eines Kompensationsfeldes anzubringen, um den glockenförmigen Feldverlauf auszugleichen. Eine derartige Konstruktion hat jedoch den Nachteil, daß die Höhenabmessung der betreffenden Magnetblasen-Baueinheit nicht unwesentlich vergrößert wird und/oder der Leistungsbedarf steigt.

Andererseits ließe sich auch eine derartige Feldkompensation durch entsprechendes Anordnung von Permanentmagneten herbeiführen, wobei außerdem auch entsprechend angebrachte Plättchen hoher Permeabilität die gleiche Wirkung herbeizuführen vermögen. Jedoch ist hierbei der Nachteil zu verzeichnen, daß sich ein schädlicher Einfluß auf die Verteilung des zum Drehmagnetfeld senkrecht gerichteten Stützmagnetfeldes für die Beibehaltung der Magnetblasen innerhalb der Magnetschicht ergibt. Maßnahmen dieser Art finden sich in den US-Patentschriften 3 927 397 und 4 068 219.

Darüberhinaus sind auch noch andere orthogonal Flachsolenoidsysteme für Magnetblasen-Baueinheiten bekannt, bei welchen die Drehfeldsolenoide nicht die Magnetblasenchips einschließen. Bei einem von diesen Systemen werden zwei Paare derartiger, orthogonal zueinander ausgerichter Flachspulen so angebracht, daß die Magnetblasenchips zwischen die beiden Flachspulenpaaren zu liegen kommen. Bei einem anderen dieser Flachspulensysteme, bekannt als Spulenspiegelabbildungssystem, liegt nur ein einziges Spulenpaar, bestehend aus zueinander orthogonal gerichteten Flachspulen, zu einer Seite von Magnetblasenchips vor, welches mit einer auf der anderen Magnetblasenchipseite angebrachten, reflektierenden Leiterplättchen zusammenwirkt, so daß gegenüber dem zuerst beschriebenen Doppelspulenpaarsystem das eine der Flachspulenpaare entfallen kann. Eine entsprechende Beschreibung ist der Veröffentlichung: "Reflection Coil Packaging For Bubble Devices", von Masaki Takasu u. a. in "IEEE Trans. On Magnetics", Mag. 11, Nr. 5, Seiten 1151 ff, 1975 beschrieben. In der USA-Patentschrift 4 027 300 ist ein anderes Spulenspiegelabbildungssystem für Magnetblasen-Baueinheiten gezeigt.

Allen oben beschriebenen Orthogonalspulensystemen zur Bereitstellung von sich in Magnetschichtebene drehenden, zur Weiterleitung von in der Magnetschicht enthaltenden Magnetblasen dienenden Drehmagnetfeldern ist gemeinsam, daß unter Verwendung von Flachspulen - und bei letzterem auch Solenoidsystemen -, die zu beeinflussenden Magnetblasenchips nicht innerhalb der Spulen selbst liegen. Es sind also hier keine Spulensysteme mit inneren und äußeren Spulen und mit innerhalb der inneren Spule angeordneten Magnetblasenchips vorgegeben. Bei derartigen Spulenspiegelabbildungssystemen kann darüberhinaus auch nicht das leitende Spiegelplättchen zu irgendeinem Magnetfeldausgleich des durch die Spulenmitte gelangenden Magnetfeldflusses beitragen, so daß infolgedessen hiermit auch nicht Probleme gelöst werden können, die im Zusammenhang mit Einschließungsspulensystemen auftreten, die innerhalb ihrer inneren Spule die Magnetblasenchips enthalten.

Unter diesen Voraussetzungen besteht die Aufgabe der Erfindung, wie sie in den Ansprüchen gekennzeichnet ist, darin, eine Magnetblasenbaueinheit mit Umfassungssolenoidsystem bereitzustellen, bei dem zur Herabsetzung und/oder Unschädlich-machen von Welligkeiten in der Gleichförmigkeit des Drehmagnetfeldes, also zur Herbeiführung einer gleichförmigen Drehmagnetfeldverteilung, Maßnahmen bereitgestellt werden, die bei geringstmöglichem Aufwand zu einem kompakten, leicht herstellbaren Bauelement mit vergleichsweise geringem Leistungsbedarf führen.

Die Lösung der gestellten Aufgabe ergibt sich aus dem Kennzeichen des Patentanspruchs 1. Vorteilhafte Weiterbildungen und Ausgestaltungen der Erfindung sind in den Unteransprüchen angegeben.

Die durch die Erfindung erreichten Vorteile lassen sich darin sehen, daß sich dank der Erfindung eine Magnetblasen-Baueinheit ergibt, die bei relativ kompakten Aufbau keine großen Toleranzansprüche stellt und wobei zu dem noch dank Magnetfeldausgleichs-Leitungsfolien eine wirksame elektromagnetische Abschirmung gegenüber Hochfrequenzeinstrahlung besteht. Die sich fernerhin ergebende relativ geringe Packungshöhe führt außerdem zu Montagevorteilen bei Einbau in ein Gesamtsystem, so daß sowohl bei Herstellung als auch bei Betrieb der erfindungsgemäßen Anordnung nicht unbeachtliche Aufwandsverringerungen zu verzeichnen sind.

Die Erfindung wird nun anhand einer Ausführungsbeispielsbeschreibung mit Hilfe der unten aufgeführten Zeichnungen näher erläutert.

Es zeigen:

Fig. 1    eine Querschnittsdarstellung eines bevorzugten Ausführungsbeispiels einer Feldzugriffs-Magnetblasen-Baueinheit gemäß der Erfindung;

Fig. 2    eine perspektivische Explosionsansicht einer Teilanordnung der in Fig. 1 gezeigten Baueinheit;

Fig. 3    eine perspektivische Teilansicht einer schematisch dargestellten Teilanordnung der in Fig. 1 gezeigten Baueinheit, aus welcher die Anordnung der Drehfeldsolenoidwicklungen zu entnehmen ist;

Fig. 4    einen Ausschnitt der inneren Solenoidwicklung gemäß dem Stand der Technik;

Fig. 5    einen Ausschnitt der Wicklung des inneren Solenoids mit Magnetfeldausgleichs-Leitungsfolien gemäß der Erfindung;

Fig. 6    eine graphische Darstellung der Magnetfeldverteilung unter Verwendung einer Solenoidanordnung gemäß dem Stand der Technik;

EN 977 019

Fig. 7    die graphische Darstellung der Magnetfeldverteilung
          unter Anwendung einer Solenoidanordnung gemäß der
          Erfindung;

Fig. 8    ein zweites Ausführungsbeispiel für die erfindungsgemäße Solenoidanordnung;

In den Darstellungen sind gleiche Bauelemente jeweils mit denselben Bezugszeichen versehen.

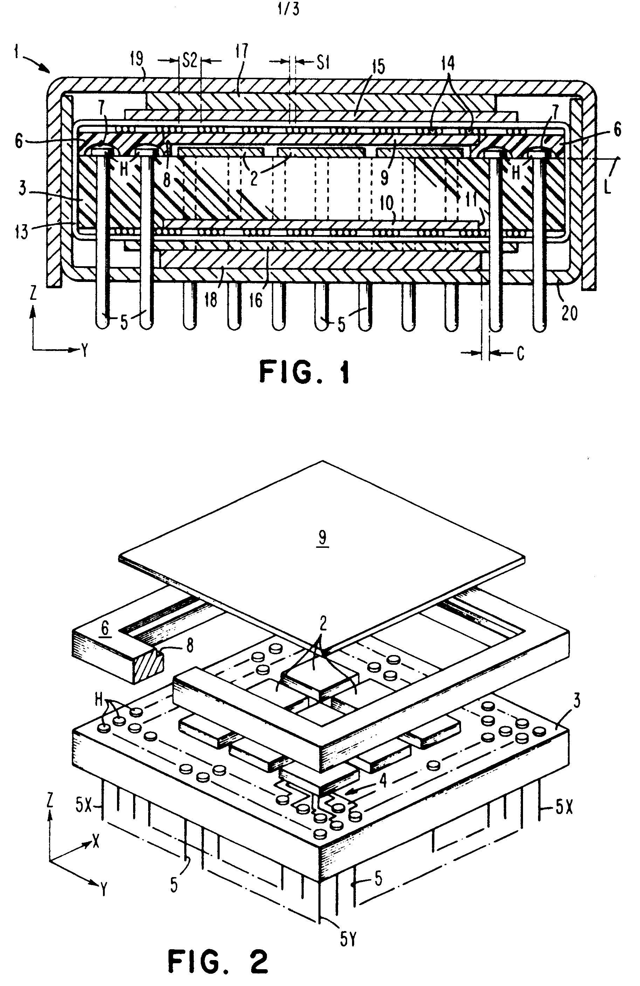

Die erfindungsgemäße Magnetblasenbaueinheit 1 in Fig. 1
weist eine spezielle Ebene L auf, die eine Anzahl von Magnetblasenchips 2 trägt. Wie es sich aus der der Darstellung
nach Fig. 2 zu gewinnenden Übersicht ergibt, sind die Magnetblasenchips 2 in einer 3x3-Matrix auf dieser Ebene L angeordnet. Bei der praktischen Ausgestaltung der Baueinheit 1
sind die Magnetblasenchips auf der oberen Oberfläche eines
rechtwinkligen, vorzugsweise quadratischen, ebenen Keramiksubstrats 3 montiert. Die obere Oberfläche des Substrats 3
trägt außerdem ein gedrucktes Leitungszugsmuster 4 (Fig. 2).
Die hier nicht gezeigten Anschlußstellen auf dem Magnetblasenchips 2, die sich auf den unteren Oberflächen der Magnetblasenchips 2 befinden, sind mit entsprechenden Anschlußstellen des Leitungszugsmusters 4 z. B. durch Löten verbunden. Die Einzelleitungszüge des Leitungszugsmusters 4 ihrerseits enden an und sind befestigt mit den Köpfen H (Fig. 1),
die zu Anschlußstiften gehören, die ihrerseits in parallelen
Doppelreihen, längs der Substratkanten verlaufend, angeordnet sind. So hat beispielsweise die Magnetblasen-Baueinheit 1
eine Gesamtzahl von 72 Anschlußstiften 5, wobei 40 Anschlußstifte 5 längs der Außenkanten des Substrats 3 und 32 parallel hierzu im inneren Teil liegen. Die in Parallelreihen angeordneten Anschlußstifte 5 sind zudem noch zeilen-
und spaltenweise zueinander ausgerichtet.

EN 977 019

Ein Isolierrahmen 6 ist, längs der Außenkanten des Substrats 3 verlaufend,oberhalb der Anschlußstiftköpfe H aufgebracht, indem hierin geeignete Ausnehmungen 7 für die Anschlußstiftköpfe H eingebracht sind, so daß bei Montage der Isolierrahmen 6 schlüssig auf Substrat 3 zu liegen kommt, wobei zu dem noch die Kanten beider Bauelemente miteinander fluchten. Eine längs der Innenkante des Isolierrahmens 6, an der der Substratoberfläche abgewandten Oberfläche verlaufende Kehle 8 dient zur Aufnahme einer elektrisch leitenden, nicht-magnetischen, vorzugsweise aus Kupfer bestehenden Folie 9. Die äußeren Oberflächenbereiche des Isolierrahmens 6 sind mit der Oberfläche der eingelegten Folie 9 in gleicher Ebene liegend angeordnet. Im bevorzugten Ausführungsbeispiel ist eine weitere elektrisch leitende, nicht-magnetische, vorzugsweise aus Kupfer bestehende Folie 10 mit im wesentlichen gleichen Abmessungen wie die der Folie 9 in eine quadratische Ausnehmung 11 in der unteren Oberfläche des Substrats 3, der Folie 9 genau gegenüberliegend, eingelassen. Auch hier wiederum sind die Oberflächenbereiche des Substrats 3 mit der betreffenden Oberfläche der Folie 10 in gleicher Ebene liegend angeordnet, wobei, wie gesagt, die Folien 9 und 10 im wesentlichen gleiche Abmessungen aufweisen.

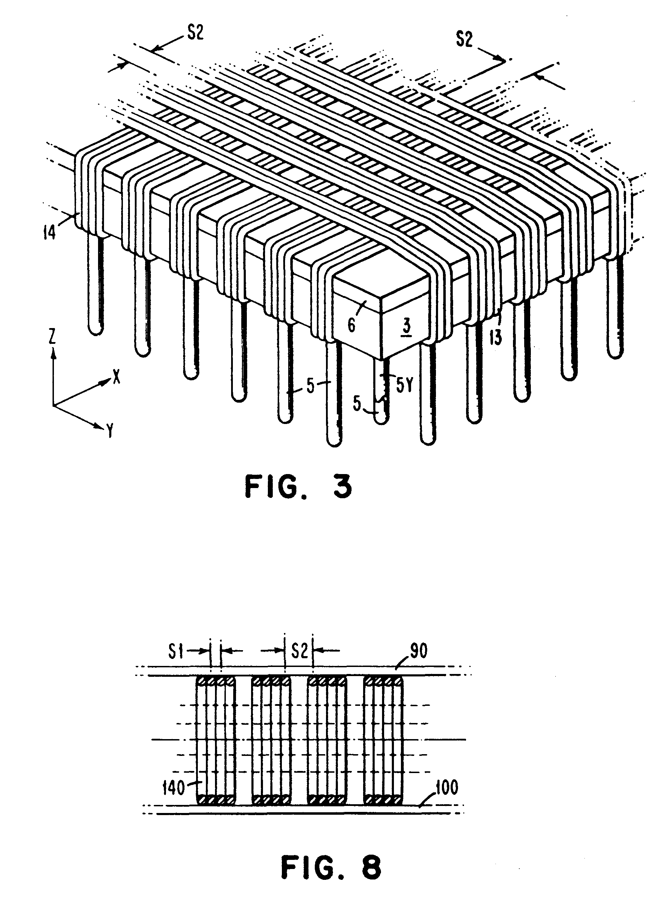

Wie weiterhin aus Fig. 1 und in größerer Klarheit noch aus Fig. 3 hervorgeht, weist die Magnetblasen-Baueinheit ein Solenoidsystem auf, daß die Magnetblasenchips 2 einschließt, und zwar bestehend aus den orthogonal zueinander ausgerichteten Solenoiden 13 und 14. Das innere Solenoid 14 stellt so z. B. die Y-Spule zur Bereitstellung des Steuerdrehmagnetfeldes dar und besteht aus um das Substrat 3 über die in Y-Richtung verlaufenden, gegenüberliegenden Substratkanten gelegten Windungen isolierten Drahtes. Auf die Weise ergeben sich jeweils Einzelwicklungen des Solenoids 14 in den Abständen zwischen spaltenweise zueinander ausgerichteten Anschlußstiften 5. Beim zuvor speziell erwähnten Ausführungsbeispiel für die Anordnung der Anschlußstifte 5 weist das Solenoid 14 zehn Wicklungen, enthaltend jeweils gleiche Windungszahl auf. Der Wicklungsabstand S1 im inneren Solenoid 14 ist überall gleich ebenso wie der Wicklungsabstand S2 im äußeren Solenoid 14. Jedoch ist der Wicklungsabstand S2 sehr viel größer als der Wicklungsabstand S1, und zwar aufgrund der relativen Abmessungen des Leiterdurchmessers beim Solenoid 14 und der betreffenden Leitungsisolationsdicke hinsichtlich des Anschlußstiftsdurchmessers.

In gleicher Weise ist das äußere Solenoid 13 zur Bereitstellung der X-Feldkomponente durch Umwickeln des innern Solenoids 14 in hierzu orthogonaler Richtung mit isoliertem Spulendraht hergestellt. Mit anderen Worten das äußere Solenoid 13 ist um die in X-Richtung verlaufenden Substratkanten gewickelt, die senkrecht zu den Substratkanten zur Aufnahme des inneren Solenoids 14 liegen. Auch hier wiederum ergibt sich, daß Einzelwicklungen des äußeren Solenoids 13 in den Abständen zwischen den zeilenweise ausgerichteten Anschlußstiften 5 zuliegen kommen. Demgemäß besteht also im vorliegenden Beispiel auch das äußere Solenoid 13 aus zehn Wicklungen jeweils gleicher Windungszahl. Die Anschlüsse der Solenoide 13 und 14 sind mit entsprechenden Anschlußstiftpaaren, die diametral einander gegenüber liegen, nämlich den Eckanschlußstiften 5X bzw. 5Y, verbunden.

Wie aus Fig. 1 weiterhin ersichtlich liegen den äußeren Oberflächen der äußeren Solenoide 13 hochpermeable magnetische ebene Plättchen 15, 16 gegenüber. Das untere hochpermeable Plättchen 16 weist isolierte Öffnungen für den Durchlaß der inneren Anschlußstiftreihen 5 auf. Weiterhin liegen oberhalb bzw. unterhalb der hochpermeablen magnetischen Plättchen 15 und 16 Permanentmagnetplättchen 17 bzw. 18. Die Abmessungen des Permanentmagnetplättchens 18 sind dabei so gewählt, daß ausreichender Zwischenraum C zwischen seiner Außenkante und der inneren Anschlußstiftreihe 5 vorliegt.

Die gesamte Teilanordnung 2 bis 18 ist in einem zweiteiligen Gehäuse 19, 20 untergebracht, das seinerseits aus hochpermeablen magnetischem Material besteht. Der untere Gehäuseteil 20 ist kästchenförmig aus vier Seitenwänden mit einem Boden ausgebildet; wobei letzterer isolierte Öffnungen für den Durchlaß der Anschlußstifte 5 aufweist. Der als Deckel dienende Gehäuseteil 19 ist ebenfalls kästchenförmig mit einem Deckelteil und vier Seitenwänden ausgebildet, und zwar so, daß der Deckelteil über Gehäuseteil 20 gestülpt werden kann. Die Gesamtmagnetblasen-Baueinheit 1 läßt sich dann in bewährter Weise versiegeln.

Das durch die Permanentmagnetplättchen 17, 18 bereitgestellte Stützmagnetfeld gewährleistet die Beibehaltung stabiler Magnetblasen vorgegebener Abmessung in der jeweiligen Magnetblasenschicht der Magnetblasenchips 2, wie es an sich bereits bekannt ist. Das so bereitgestellte permanente Stützmagnetfeld gewährleistet grundsätzlich die Energieunabhängigkeit der Magnetblasenchips 2. Zur Verschiebung der Magnetblasen in der jeweiligen Magnetblasenschicht dienen dann durch die orthogonal zueinander ausgerichteten Solenoide 13, 14 bereitgestellte Drehfeldkomponenten. Die bei der Magnetblasen-Baueinheit 1 verwendete spezielle Stützmagnetfeldstruktur ist als sog. geschlossene Feldstruktur bekannt geworden, die aus den Permanentmagnetplättchen 17, 18 und dem hochpermeablen Bauelementen 15, 16, 19, 20 besteht.

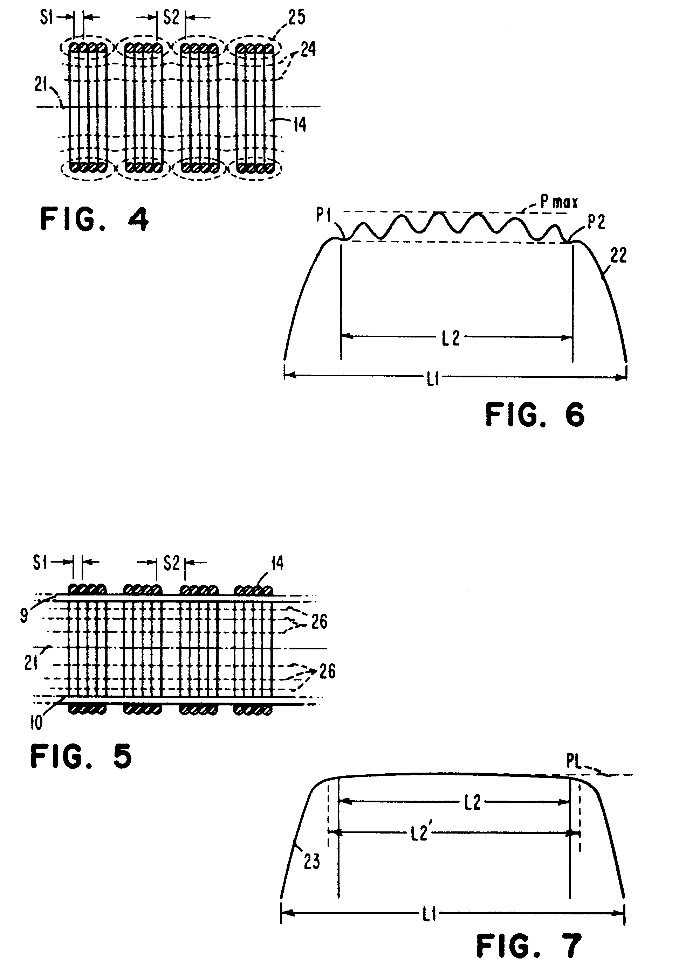

Wie an sich weiterhin bekannt, dient das durch die Solenoide 13, 14 bereitgestellte Steuerdrehmagnetfeld zur Weiterleitung von Magnetblasen in den Magnetblasenschichten der Magnetblasenchips 2. Zum vollen Verständnis vorliegender Erfindung werden nun die Fign. 4 bis 7 herangezogen. In den Darstellungen nach Fig. 4 und 5 ist jeweils ein Ausschnitt des inneren Solenoids 14 längs der Mittellinie gezeigt, die senkrecht zu den Windungen ausgerichtet ist. Hierbei ist in

EN 977 019

Fig. 4 gemäß dem Stand der Technik keine Magnetfeldausgleichs-Leitungsfolie vorgesehen, während bei der Anordnung nach Fig. 5 gemäß der Erfindung jeweils eine oberhalb und unterhalb der Mittellinie 21 dargestellt ist. Die graphischen Darstellungen nach Fig. 6 und 7 stellen schematisierte Verläufe der Drehmagnetfeldkomponenten, hervorgerufen durch das innere Solenoid 14, dar, wobei die magnetische Feldstärke über die Länge L1 des inneren Solenoids 14 längs seiner Mittellinie 21 dargestellt ist. Es wird hervorgehoben, daß bei den Voraussetzungen nach Fig. 4, also bei Nicht-Vorhandensein von Magnetfeldausgleichs-Leitungsfolien, der entsprechende Verteilungsverlauf in Gestalt der Kurve 22 in Fig. 6 eine Maximalamplitude $P_{max}$ und zwei Minimalamplituden P1, P2 innerhalb eines gewissen aktiven Bereichs zur Beherbergung der Magnetblasenchips 2 aufweist, wobei die Abmessung dieses Bereichs durch die lineare Abmessung L2 parallel zur Mittellinie 21 angedeutet ist. Demgegenüber ergibt sich aus dem durch die Kurve 23 wiedergegebenen Verlauf in der graphischen Darstellung nach Fig. 7, daß bei Vorhandensein von Magnetfeldausgleichs-Leitungsfolien 9 und 10 innerhalb des inneren Solenoids 14 die Feldverteilung des Steuerdrehmagnetfeldes innerhalb des inneren Solenoids 14 einen im wesentlichen gleichförmigen Pegel PL über der gesamten Dimension L2 aufweist. Darüberhinaus ergibt sich für eine Gesamtlänge L1 des inneren Solenoids 14, daß der aktive Bereich zum Einbringen von Magnetblasenchips 2, wie durch die Abmessung des Pegels L2' angedeutet, noch größer ist und damit dank der Erfindung auch die Möglichkeit besteht eine größere Anzahl von Magnetblasenchips 2 als bisher innerhalb des inneren Solenoids 14 unterzubringen.

Zusätzlich ergibt sich aus der Darstellung nach Fig. 4 die Flußverteilung innerhalb des inneren Solenoids 14, also für den Fall, daß keine Magnetfeldausgleichs-Leitungsfolien 9 und 10 im Solenoid 14 angeordnet sind; wobei, wie angedeutet, wellenförmig verlaufende Feldlinien 24 zu verzeichnen sind. Dies ergibt sich aus dem Einfluß des Streufeldes zwischen benachbarten Wicklungen des inneren Solenoids 14, die, wie gesagt,durch die Abstände S1 und S2 vorgegeben sind. Dieser Streufluß ist durch die gestrichelten Elipsen 25 angedeutet. Daraus ergibt sich eine gewissen Welligkeit in der Steuerdrehfeldverteilung des inneren Solenoids 14, wie durch den Verlauf der Kurve 22 in der graphischen Darstellung nach Fig. 6 angedeutet. Werden jedoch im inneren Solenoid 14 Magnetfeldausgleichsfolien 9, 10 vorgesehen, dann wird der Einfluß des genannten Streumagnetfeldes unschädlich gemacht, so daß keinerlei Auswirkung auf die Flußverteilung innerhalb des inneren Solenoids 14 vorliegt. Somit verlaufen die Feldlinien im wesentlichen, wie durch die Parallellinien 26 in der Darstellung nach Fig. 5 angedeutet, gleichförmig. Als Resultat zeigt sich, daß die Steuerdrehmagnetfeldverteilung gemäß Kurve 23 in der graphischen Darstellung nach Fig. 7 im wesentlichen welligkeitsfrei ist.

Ähnliche gleichförmige Steuerdrehmagnetfeldverteilung bei Unterdrückung des Welligkeitseffekts, verursacht durch die Abstände S1 und S2 des äußeren Solenoids 13, ergibt sich innerhalb des inneren Solenoids 14, und zwar zu gegenüber vorher in orthogonaler Richtung, wenn die Magnetfeldausgleichs-Leitungsfolien 9, 10, wie gezeigt, vorgesehen werden.

Aus den Darstellungen nach den Fign. 4 und 5 dürfte es offensichtlich sein, daß bei Vorhandensein von Magnetfeldausgleichs-Leitungsfolien die Abmessungen der Montierungsebene L innerhalb des inneren Solenoids 14 nicht so kritisch sind, wie es der Fall ist, wenn diese Magnetfeldausgleichs-Leitungsfolien nicht vorhanden sind. Mit anderen Worten die Toleranzbedingungen zum Montieren der Magnetblasenchips 2 innerhalb des inneren Solenoids 14 bezüglich der Bezugsachsen X, Y, Z lassen sich unter Vorsehen von Magnetfeldausgleichs-Leitungsfolien gemäß der Erfindung großzügiger handhaben. So sind die Magnetfeldausgleichs-Leitungsfolien 9, 10 vorzugsweise sehr dünn, z. B. 0,01 nm stark. Darüberhinaus versteht es sich, daß bei bestimmten Anwendungsarten, wo ein gewisser Anteil an Welligkeit und/oder Feldverzerrung zulässig ist nur eine der Magnetfeldausgleichs-Leitungsfolien 9, 10, vorzugsweise jedoch die im aktiven Bereich des Magnetblasenchips 2 liegende, also Magnetfeldausgleichs-Leitungsfolie 9 allein, vorgesehen werden kann. In zweckmäßiger Weise besitzen beide Magnetfeldausgleichs-Leitungsfolien 9 und 10 gleiche Seitenabmessungen, die jeweils angenähert 15 bis 20 % länger sind als entsprechende Seitenabmessungen des aktiven Bereichs; sie können jedoch 15 bis 20 % geringer sein als die Länge L1 des inneren Solenoids 14, gemessen längs ihrer Mittellinie.

In einem abgewandelten Ausführungsbeispiel der Erfindung lassen sich die Magnetfeldausgleichs-Leitungsfolien an den Außenseiten des inneren Flachsolenoids 14 entweder zwischen beiden Solenoiden oder auch sogar auf der Außenseite des äußeren Solenoids 13 aufbringen. Wie es z. B. in Fig. 8 gezeigt ist, befinden sich die Magnetfeldausgleichs-Leitungsfolien 90, 100 an den Außenseiten des inneren Flachsolenoids 140, d. h. zwischen dem inneren Flachsolenoid 140 und dem äußeren hier nicht gezeigten Flachsolenoid. Es sei aber darauf hingewiesen, daß eine entweder zwischen den beiden Flachsolenoiden oder auf der Außenseite des äußeren Flachsolenoids angeordneten Magnetfeldausgleichs-Leitungsfolie 90 und 100 in diesem Ausführungsbeispiel nicht so wirksam sein kann, wie beide Magnetfeldausgleichs-Leitungsfolien beim Ausführungsbeispiel nach den Fign. 1 bis 3 und 5.

Es sind noch weitere Abwandlungen hinsichtlich der Ausführungsbeispiele der Erfindung denkbar. So können z. B. mehrere Montierungsebenen L für Magnetblasenchips 2 innerhalb des inneren Solenoids vorgesehen sein, wobei die Magnet-

EN 977 019

feldausgleichs-Leitungsfolien immer zwischen innerem Solenoid 14 und diesen Magnetblasenchips 2 zuliegen kommen. Zudem könnten auch die Solenoide 13, 14 als Einschlußsystem
aus gedruckten Schaltungssolenoidtypen bestehen.

P A T E N T A N S P R Ü C H E

1. Magnetblasenbaueinheit für Feldzugriffsbetrieb, bei dem zur Bereitstellung eines Steuerdrehmagnetfeldes für die Weiterleitung von Magnetblasen in einer Magnetblasenschicht ein inneres Flachsolenoid in hierzu orthogonaler Richtung von einem äußeren Flachsolenoid umfaßt ist, wobei innerhalb des inneren Flachsolenoids zumindest ein eine Magnetblasenschicht aufweisendes Magnetblasenchip angeordnet ist, dadurch gekennzeichnet, daß benachbart zu Oberflächen beider Flachsolenoide (13, 14) eine Magnetfeldausgleichs-Leitungsfolie (9) zur Herbeiführung einer gleichmäßigen Magnetflußverteilung lung über der jeweiligen Magnetblasenschicht zumindest im der Magnetblasenschicht benachbarten Bereich vorgesehen ist.

2. Anordnung nach Anspruch 1, dadurch gekennzeichnet, daß ein Paar von Magnetblasenchips (2) einschließender Magnetfeldausgleichs-Leitungsfolien (9, 10) vorgesehen ist.

3. Anordnung nach Anspruch 1 und/oder 2, dadurch gekennzeichnet, daß bei an den Außenkanten eines sowohl die Magnetblasenchips (2) als auch die Flachsolenoide (13, 14) tragenden Substrats (3) vorgesehenen Anschlußstiftreihen und hierdurch bedingter Aufteilung der einzelnen Flachsolenoiden (13, 14) in Einzelwicklungen, die die Magnetblasenchips (2) tragende Substratoberfläche mit einem die betreffende Magnetfeldausgleichs-Leitungsfolie (9) tragenden, zudem die Köpfe (H) der Anschlußstifte (5) abdeckenden, mit dem Substratkanten fluchtenden Isolierrahmen (6) abgedeckt ist.

EN 977 019

4. Anordnung nach den Ansprüchen 1 bis 3, gekennzeichnet durch eine Permanentstützmagnetfeldstruktur.

5. Anordnung nach den Ansprüchen 1 bis 4, dadurch gekennzeichnet, daß die Magnetfeldausgleichs-Leitungsfolien (9, 10) jeweils 0,1 mm stark sind und etwa 15 bis 20 % längere Seitenabmessungen als der jeweilige aktive Bereich mit den Magnetblasenchips (2) aufweisen, jedoch 15 bis 20 % kleiner sind als die Länge des inneren Solenoids (14), gemessen an ihrer Mittellinie.

0006443

1/3

FIG. 1

FIG. 2

FIG. 3

FIG. 8

FIG. 4

FIG. 6

FIG. 5

FIG. 7

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | IEEE TRANSACTIONS ON MAGNETICS, Vol. 9, Nr. 3, September 1973, New York, US, A.A. RIFKIN: "A practical approach to packaging magnetic bubble devices", Seiten 429-433 <br><br> * Seite 430, rechte Spalte, Zeile 1 bis Seite 431, linke Spalte, Zeile 3; Figuren 3,4 * <br><br> -- | 1-3 |
| | IBM TECHNICAL DISCLOSURE BULLETIN, Vol. 20, Nr. 1, Juni 1977, New York, US, BEKKERS et al.: "Homogeneous rotating field for bubble chip with optical access", Seiten 365-366 <br><br> * Ganz * <br><br> ---- | 1,5 |

**KLASSIFIKATION DER ANMELDUNG (Int.Cl.3)**

G 11 C 19/08
G 05 F 7/00

**RECHERCHIERTE SACHGEBIETE (Int. Cl.²)**

G 11 C 19/08

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 26-09-1979 | DEGRAEVE |